# EUROPEAN PATENT APPLICATION

(11) **EP 4 528 908 A1**
(43) Date of publication of application: **26.03.2025**
(21) Application number: 24794686.6
(22) Date of filing: 31.07.2024
(51) Int. Cl.: H01M 50/507, H01M 50/519, H01M 50/503, H01M 50/569

(54) **BATTERY MODULE**

(30) Priority: 09.08.2023 CN 202322134282 U
(71) Applicant: Eve Energy Co., Ltd., Huizhou, Guangdong 516006 (CN)
(72) Inventor: NING, Fengfeng, Huizhou Guangdong 516006 (CN)
(74) Representative: HGF
(86) International application number: PCT/CN2024/108668
(87) International publication number: WO 2025/031223

(57) **Abstract**

Provided is a battery module. The battery module includes multiple cell assemblies, a printed circuit board, PCB, (100) and a connecting bar assembly (200). The PCB (100) is etched with a voltage collection circuit. The connecting bar assembly (200) includes multiple connecting bars (210), where each of the multiple connecting bars (210) includes a connecting bar body (211) and a cantilever structure (212) connected to the connecting bar body (211), multiple connecting bars (210) of the same connecting bar assembly (200) are disposed in one-to-one correspondence with multiple cells of the same cell assembly, a connecting bar body (211) of each multiple connecting bar (210) is connected to a positive electrode of a corresponding one of the multiple cells or a negative electrode of a corresponding one of the multiple cells, cantilever structures (212) of any two adjacent connecting bars (210) are electrically connected, all cantilever structures (212) of the multiple connecting bars (210) are welded to the PCB (100), and the voltage collection circuit is configured to collect a voltage of each cantilever structure (212).

## Description

This application claims priority to Chinese Patent Application No. 202322134282.1 filed with the China National Intellectual Property Administration (CNIPA) on Aug. 9, 2023, the disclosure of which is incorporated herein by reference in its entirety.

### TECHNICAL FIELD

The present application relates to the technical field of batteries, for example, a battery module.

### BACKGROUND

At present, a voltage sensor and a voltage collection circuit are generally disposed on a busbar to collect a voltage of a battery module.

### TECHNICAL PROBLEM

The related art provides an integrated bus module. A busbar of the integrated bus module is directly disposed on a printed circuit board (PCB), and the PCB supports the busbar to reduce the occupation of space of the module. In addition, the busbar is connected to the PCB by a collecting sheet, and a voltage collection circuit disposed on the PCB collects a voltage of the busbar by using the collecting sheet to detect the voltage of the battery module. However, in the integrated bus module, the busbar needs to be connected to the PCB by a dedicated collecting sheet. For a busbar that needs to be connected in series and parallel, a structure is still relatively complex.

### TECHNICAL SOLUTION

The present application provides a battery module. The battery module includes multiple cell assemblies, a PCB and a connecting bar assembly.

A cell assembly includes multiple cells.

The PCB is etched with a voltage collection circuit.

The connecting bar assembly includes multiple connecting bars, a connecting bar includes a connecting bar body and a cantilever structure, the cantilever structure is connected to the connecting bar body, the multiple connecting bars of the same connecting bar assembly are disposed in one-to-one correspondence with the multiple cells of the same cell assembly, the connecting bar body of each connecting bar is connected to a positive electrode of a corresponding cell or is connected to a negative electrode of a corresponding cell, cantilever structures of any two adjacent connecting bars are electrically connected, all cantilever structures of the multiple connecting bars are welded to the PCB, and the voltage collection circuit is configured to collect voltages of the cantilever structures.

### BENEFICIAL EFFECTS

The present application has the beneficial effects described below.

The present application provides a battery module. The battery module includes a PCB and a connecting bar assembly. The PCB is etched with a voltage collection circuit. The connecting bar assembly includes multiple connecting bars. The connecting bar includes a connecting bar body and a cantilever structure connected to the connecting bar body. Multiple connecting bars of the same connecting bar assembly are disposed in one-to-one correspondence with multiple cells of the same cell assembly. The connecting bar body of each connecting bar is connected to a positive electrode of a corresponding cell or a negative electrode of the corresponding cell. Cantilever structures of any two adjacent connecting bars are electrically connected so that the multiple cells of the cell assembly are connected in parallel. Moreover, the cantilever structures of the multiple connecting bars are welded to the PCB. The voltage collection circuit is configured to collect the voltage of each cantilever structure, thereby implementing the collection of a voltage of the connecting bar. Since two adjacent connecting bars are connected by cantilever structures, the voltage collection circuit directly collects voltages of the cantilever structures so that a collecting sheet does not need to be additionally disposed and a structure is simple.

### BRIEF DESCRIPTION OF THE DRAWINGS

FIG. 1 is a structure diagram of a battery module according to some embodiments of the present application.
FIG. 2 is an enlarged view of part A of FIG. 1.
FIG. 3 is a top view of a battery module according to some embodiments of the present application.
FIG. 4 is a structure diagram of a connecting bar according to some embodiments of the present application.
FIG. 5 is a structure diagram of another battery module according to some embodiments of the present application.

### Reference list

- 100: PCB
- 200: connecting bar assembly
- 210: connecting bar
- 211: connecting bar body
- 2111: positive electrode connection portion
- 2112: negative electrode connection portion
- 212: cantilever structure
- 2121: cantilever mounting member
- 2122: cantilever
- 2123: bent portion
- 2124: extending portion
- 300: fuse
- 400: temperature collection device
- 500: busbar

### EMBODIMENTS OF THE DISCLOSURE

In the description of the present application, terms "joined", "connected" and "fixed" are to be understood in a broad sense unless otherwise expressly specified and limited. For example, the term "connected" may refer to "fixedly connected", "detachably connected", or "integrated", may refer to "mechanically connected" or "electrically connected", or may refer to "connected directly", "connected indirectly through an intermediary", or "connected inside two elements" or "an interaction relation between two elements". For those of ordinary skill in the art, specific meanings of the terms in the present application may be understood based on specific situations.

In the present application, unless otherwise specified and limited, when a first feature is described as being "on" or "below" a second feature, the first feature and the second feature may be in direct contact or be in contact via another feature between the two features instead of being in direct contact. Moreover, when the first feature is described as "on", "above", or "over" the second feature, the first feature is right on, above, or over the second feature, the first feature is obliquely on, above, or over the second feature, or the first feature is at a higher level than the second feature. When the first feature is described as "under", "below", or "underneath" the second feature, the first feature is right under, below, or underneath the second feature, the first feature is obliquely under, below, or underneath the second feature, or the first feature is at a lower level than the second feature.

In the description of this embodiment, it is to be noted that orientations or position relations indicated by terms such as "above", "below", "left" and "right" are based on the drawings. These orientations or position relations are intended to facilitate the description and simplify an operation and not to indicate or imply that a device or element referred to must have such particular orientations or must be configured or operated in such particular orientations. Thus, these orientations or position relations are not to be construed as limiting the present application. In addition, the terms "first" and "second" are used to distinguish between descriptions and have no special meaning.

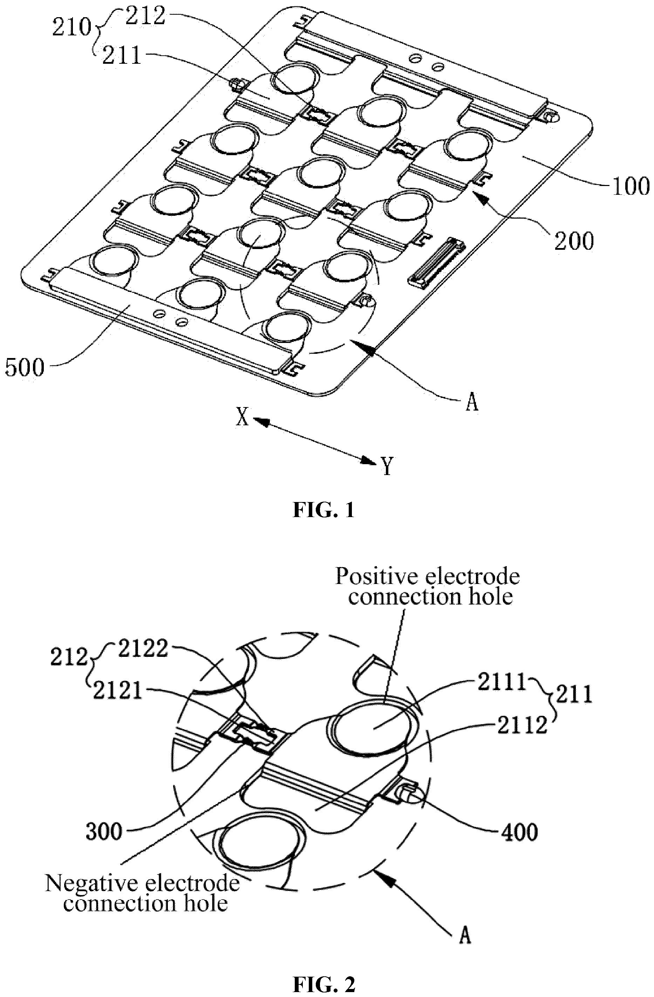

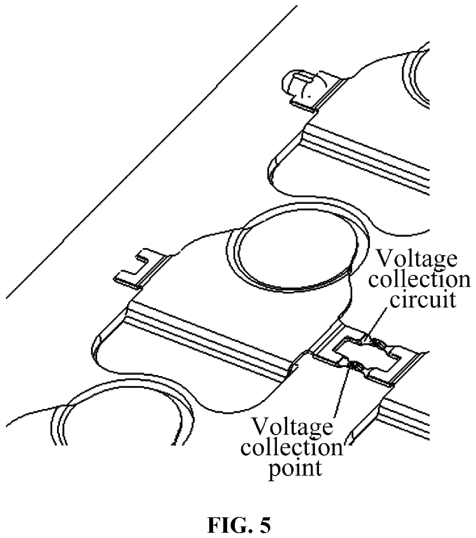

Referring to FIGS. 1 to 5, a battery module includes multiple cell assemblies, the cell assembly includes multiple cells, and the battery module further includes a PCB 100 and a connecting bar assembly 200, where the PCB 100 is etched with a voltage collection circuit. The connecting bar assembly 200 includes multiple connecting bars 210, the connecting bar 210 includes a connecting bar body 211 and a cantilever structure 212, the cantilever structure 212 is connected to the connecting bar body 211, multiple connecting bars 210 of the same connecting bar assembly 200 are disposed in one-to-one correspondence with multiple cells of the same cell assembly, the connecting bar body 211 of each connecting bar 210 is connected to a positive electrode of a corresponding cell or a negative electrode of a corresponding cell, and cantilever structures 212 of any two adjacent connecting bars 210 are electrically connected so that the multiple cells of the cell assembly are connected in parallel. Cantilever structures 212 of the multiple connecting bars 210 are welded to the PCB 100, the voltage collection circuit is configured to collect the voltage of each cantilever structure 212, and the voltage collection circuit and a voltage collection point are illustrated in FIG. 5; thus, the collection of a voltage of the connecting bar 210 is implemented. The PCB 100 can play a role in signal collection and transmission and as a carrier of an electronic component, the PCB 100 can improve integration degree, thereby omitting a plastic cover plate in a traditional solution. In addition, since two adjacent connecting bars 210 are connected by cantilever structures 212, the voltage collection circuit directly collects voltages of the cantilever structures 212 so that no additional collecting sheet is required and the structure is simple.

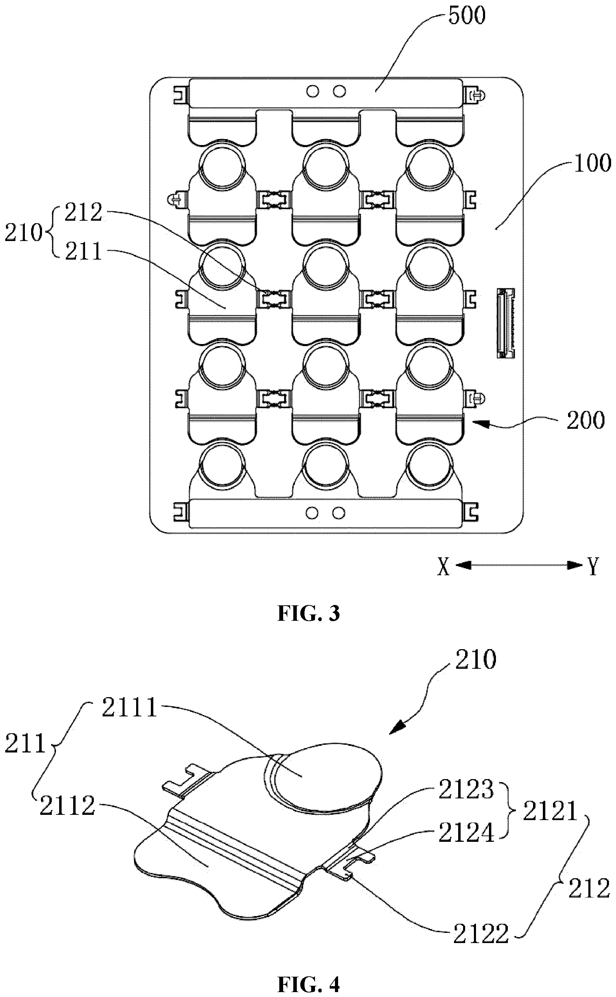

With continued reference to FIGS. 1 to 4, the multiple connecting bars 210 of the connecting bar assembly 200 are sequentially disposed in a first direction, one connecting bar 210 includes two cantilever structures 212, and the two cantilever structures 212 are disposed on two sides of the connecting bar body 211 in the first direction, respectively. The first direction is the X-Y direction in FIGS. 1 and 3. In any two adjacent connecting bars 210, two cantilever structures 212 are located therebetween. The two connecting bars 210 are just connected by the two cantilever structures 212 to simplify the connection structure between the connecting bars 210.

With continued reference to FIGS. 1 to 4, the battery module further includes a fuse 300 connected between cantilever structures 212 of any two adjacent connecting bars 210 so that the two connecting bars 210 are electrically connected. One end of the fuse 300 is connected to one cantilever structure 212 of one of the two connecting bars 210, and the other end of the fuse 300 is connected to one cantilever structure 212 of the other one of the two connecting bars 210 adjacent to the preceding cantilever structure 212. The fuse 300 is disposed between cells connected in parallel so that fuse protection can be provided between two cells connected in parallel.

With continued reference to FIGS. 1 to 4, the cantilever structure 212 includes a cantilever mounting member 2121 and two cantilevers 2122, the two cantilevers 2122 are both disposed on the cantilever mounting member 2121, two fuses 300 are disposed between cantilever structures 212 of any two adjacent connecting bars 210, and the two cantilevers 2122 of the cantilever structure 212 are connected to the two fuses 300 in one-to-one correspondence. In this manner, two fuses 300 can be disposed in parallel between two adjacent connecting bars 210 to improve safety performance.

With continued reference to FIGS. 1 to 4, in a process of assembling the cells, some cells are stacked in a vertical direction, and surfaces of upper ends of multiple stacked cells have different heights due to an effect of a common difference. In this regard, the cantilever mounting member 2121 includes a bent portion 2123 and an extending portion 2124, the bent portion 2123 is connected to the connecting bar 210, the extending portion 2124 is connected to the bent portion 2123, the extending portion 2124 extends in the first direction, the bent portion 2123 is disposed at an angle with the extending portion 2124 and is disposed at an angle with a vertical direction, and the first direction is perpendicular to the vertical direction. In this manner, the bent portion 2123 is bent relative to the extending portion 2124 to adapt to the surfaces of the upper ends of the cells having different heights and absorb the common difference of the stacking of the cells. Moreover, the bent portion 2123 can play a role in seismic absorption as a buffer structure. Optionally, the bent portion 2123 and the extending portion 2124 are connected with an arc transition.

Optionally, the cantilever structure 212 is made of an elastic material, and the bent portion 2123 and the extending portion 2124 may have elastic deformation so that both the bent portion 2123 and the extending portion 2124 can be bent and the connecting bar 210 can adapt to cells with different heights and at different positions.

With continued reference to FIGS. 1 to 4, in the first direction, among the multiple connecting bars 210 of the connecting bar assembly 200, connecting bars 210 located at two ends are end connecting bars, where one cantilever structure 212 of the end connecting bar is connected to another connecting bar 210, and the other cantilever structure 212 of the end connecting bar is not connected to another connecting bar 210. In this embodiment, temperature collection devices 400 are disposed on at least part of the end connecting bars and are disposed on cantilever structures 212 away from other connecting bars 210 so that the temperature of the connecting bars 210 can be collected by the temperature collection devices 400, that is, the temperature collection device 400 is disposed on the cantilever structure 212 that is not connected to another connecting bar 210, and in this manner, an overall structure of the battery module can be more compact. Optionally, multiple temperature collection devices 400 are provided to collect the temperature at multiple positions through the multiple temperature collection devices 400.

With continued reference to FIGS. 1 to 4, the PCB 100 has multiple bond pads, and the cantilever structures 212 of the multiple connecting bars 210 are welded to the multiple bond pads in one-to-one correspondence. The bond pads are disposed to simplify the disassembly and assembly of the connecting bars 210. In addition, the bond pads are connected to the voltage collection circuit so that the voltage collection circuit can collect the voltage of each cantilever structure 212. The fuse 300 is welded to the bond pad to facilitate the assembly and disassembly of each component.

With continued reference to FIGS. 1 to 4, the connecting bar body 211 includes a positive electrode connection portion 2111 and a negative electrode connection portion 2112, the positive electrode connection portion 2111 is configured to be connected to the positive electrode of a corresponding cell in one of the multiple cell assemblies, and the negative electrode connection portion 2112 is configured to be connected to the negative electrode of a corresponding cell in another of the multiple cell assemblies. Optionally, any cell assembly includes the same number of multiple cells. Among the cell assemblies, positive electrodes of cells in a cell assembly located at an intermediate position are connected to connecting bars 210 of one connecting bar assembly 200, and negative electrodes of the cells in the cell assembly located at the intermediate position are connected to connecting bars 210 of another connecting bar assembly 200. Cell assemblies located at two ends are a first end cell assembly and a second end cell assembly, respectively, positive electrodes of cells in the first end cell assembly are connected to connecting bars 210 of a connecting bar assembly 200, and negative electrodes of cells in the second end cell assembly are connected to connecting bars 210 of another connecting bar assembly 200. Optionally, the battery module further includes two busbars 500, one of the two busbars 500 is connected to negative electrodes of the multiple cells in the first end cell assembly, and the other busbar 500 is connected to positive electrodes of the multiple cells in the second end cell assembly.

With continued reference to FIGS. 1 to 4, a positive electrode connection hole and a negative electrode connection hole are disposed on the PCB 100, the positive electrode connection portion 2111 is disposed in the positive electrode connection hole, and the negative electrode connection portion 2112 is disposed in the negative electrode connection hole. The positive electrode connection hole and the negative electrode connection hole are provided so that both the positive electrode connection portion 2111 and the negative electrode connection portion 2112 pass through the corresponding connection holes to fit snugly around the positive electrode or the negative electrode of the cell, thereby limiting the positive electrode connection portion 2111 and the negative electrode connection portion 2112.

## Claims

1. A battery module, comprising a plurality of cell assemblies, a printed circuit board, PCB, (100), and a connecting bar assembly (200); wherein
a cell assembly of the plurality of cell assemblies comprises a plurality of cells;
the PCB (100) is etched with a voltage collection circuit; and
the connecting bar assembly (200) comprises a plurality of connecting bars (210), wherein a connecting bar (210) of the plurality of connecting bars (210) comprises a connecting bar body (211) and a cantilever structure (212) connected to the connecting bar body (211), the plurality of connecting bars (210) of a same connecting bar assembly (200) are in one-to-one correspondence with the plurality of cells of the cell assembly, the connecting bar body (211) of the connecting bar (210) is connected to a positive electrode of a corresponding cell of the plurality of cells or is connected to a negative electrode of a corresponding cell of the plurality of cells, cantilever structures (212) of any two adjacent connecting bars (210) among the plurality of connecting bars (210) are electrically connected, cantilever structures (212) of the plurality of connecting bars (210) are welded to the PCB (100), and the voltage collection circuit is configured to collect voltages of the cantilever structures (212).

2. The battery module according to claim 1, wherein the plurality of connecting bars (210) of the connecting bar assembly (200) are sequentially disposed in a first direction, one of the plurality of connecting bars (210) comprises two cantilever structures (212), and the two cantilever structures (212) are disposed on two sides of the connecting bar body (211) in the first direction, respectively.

3. The battery module according to claim 2, further comprising a fuse (300) connected between cantilever structures (212) of two adjacent connecting bars (210) among the plurality of connecting bars (210).

4. The battery module according to claim 3, wherein the cantilever structure (212) comprises a cantilever mounting member (2121) and two cantilevers (2122), wherein the two cantilevers (2122) are both disposed on the cantilever mounting member (2121), two fuses (300) are disposed between cantilever structures (212) of two adjacent connecting bars (210) among the plurality of connecting bars (210), and the two cantilevers (2122) of the cantilever structure (212) are connected to the two fuses (300) in one-to-one correspondence.

5. The battery module according to claim 2, wherein the cantilever structure (212) comprises a cantilever mounting member (2121) and a cantilever (2122), wherein the cantilever (2122) is disposed on the cantilever mounting member (2121), and the cantilever mounting member (2121) comprises a bent portion (2123) and an extending portion (2124), wherein the bent portion (2123) is connected to the connecting bar (210), the extending portion (2124) is connected to the bent portion (2123), one end of the extending portion (2124) extends in the first direction, the bent portion (2123) is disposed at an angle with the extending portion (2124) and is disposed at an angle with a vertical direction, and the first direction is perpendicular to the vertical direction.

6. The battery module according to claim 2, wherein in the first direction, among the plurality of connecting bars (210) of the connecting bar assembly (200), connecting bars (210) located at two ends are end connecting bars, and a temperature collection device (400) is disposed on at least part of the end connecting bars and is disposed on a cantilever structure (212) of the part of the end connecting bars facing away from other connecting bars (210).

7. The battery module according to any one of claims 1 to 6, wherein the PCB (100) comprises a plurality of bond pads, and the cantilever structures (212) of the plurality of connecting bars (210) are welded to the plurality of bond pads in one-to-one correspondence.

8. The battery module according to any one of claims 1 to 6, wherein the connecting bar body (211) comprises a positive electrode connection portion (2111) and a negative electrode connection portion (2112), wherein the positive electrode connection portion (2111) is configured to be connected to the positive electrode of the corresponding cell in one of the plurality of cell assemblies, and the negative electrode connection portion (2112) is configured to be connected to the negative electrode of the corresponding cell in another one of the plurality of cell assemblies.

9. The battery module according to claim 8, wherein a positive electrode connection hole and a negative electrode connection hole are formed on the PCB (100), the positive electrode connection portion (2111) is disposed in the positive electrode connection hole, and the negative electrode connection portion (2112) is disposed in the negative electrode connection hole.

10. The battery module according to any one of claims 1 to 6, wherein the cantilever structure (212) is a resilient structure.
